Europäisches Patentamt

(19) European Patent Office

Office européen des brevets

(11) Publication number: **0 010 359**
**B1**

(12) **EUROPEAN PATENT SPECIFICATION**

(45) Date of publication of patent specification: **20.02.85**

(51) Int. Cl.⁴: **H 01 L 31/06**

(21) Application number: **79301945.6**

(22) Date of filing: **19.09.79**

(54) Method of making a thin-film photovoltaic cell and photovoltaic cell made by this method.

(30) Priority: **22.09.78 US 944999**

(43) Date of publication of application:
**30.04.80 Bulletin 80/09**

(45) Publication of the grant of the patent:
**20.02.85 Bulletin 85/08**

(84) Designated Contracting States:
**BE DE FR GB IT NL**

(56) References cited:
**US-A-3 483 038**
**US-A-3 902 920**

(73) Proprietor: **UNIVERSITY OF DELAWARE**
**South College Avenue**
**Newark Delaware (US)**

(72) Inventor: **Barnett, Allen Marshall**
**2 Polaris Drive**
**Newark, Delaware (US)**

(74) Representative: **Baillie, Iain Cameron et al**
**c/o Ladas & Parry Isartorplatz 5**
**D-8000 München 2 (DE)**

Courier Press, Leamington Spa, England.

## Description

This invention relates to methods of making thin film photovoltaic cells and to such cells themselves.

A photovoltaic cell, often referred to as a solar cell, is a semiconductor junction device which converts light energy into electrical energy. A typical photovoltaic cell is a layered structure comprising five principal layers: (1) an absorber-generator, (2) a collector-converter, (3) a transparent electrical contact, (4) an opaque electrical contact and (5) an encapsulant. When light is shown through the transparent contact onto the absorber-generator, the device generates between the two contacts a voltage differential and a current.

The absorber-generator (commonly referred to as the "absorber") is a layer of semiconductor material which absorbs light photons and, as a consequence, generates minority carriers. Typically atoms of the absorber absorb photons and eject electrons thus creating pairs of negatively charged carriers (electrons) and positively charged carriers ("holes"). If the absorber is a p-type semiconductor, the electrons are minority carriers; if it is n-type, the holes are minority carriers. As minority carriers are readily annihilated in the absorber by recombination with the plentiful majority carriers, they must be transported to a region wherein they are majority carriers before they can be utilized to provide power for an electrical circuit.

The collector-converter (the "collector") is a layer of material in electrical contact with the absorber wherein the majority carriers are of the same conductivity type as the minority carriers generated in the absorber. This layer "collects" minority carriers from the absorber and "converts" them into majority carriers. If the collector is an oppositely doped region of the same semiconductor as the absorber, the photovoltaic device is a p-n junction or homojunction device. If the collector is comprised of a different semiconductor, the device is a heterojunction; and, if the collector is metal, the device is a Schottky junction.

The transparent contact is a conductive electrical contact which permits light to pass through to the absorber. It is typically either a continuous transparent sheet of conductive material or an open grid of opaque conductive material. If the transparent contact is on the same side of the photovoltaic device as the absorber, the device is referred to as being in the front wall configuration. If the transparent contact is on the opposite side, the device is said to be in the back wall configuration.

Although scientists have known the photovoltaic effect for more than a century, it is only within the past twenty-five years that it could be considered a practical means for generating electricity in useful amounts. Prior to 1950, photovoltaic devices were limited in use to highly specialized applications, such as light metering, wherein conversion efficiency was immaterial and electrical current demand was minimal.

The advent of silicon junction technology in the 1950's permitted the development of high cost, high conversion efficiency silicon junction photovoltaic cells. Arrays of such devices have been used with considerable success in the space program where cost is of little significance. However, the cost of such devices as energy generators, typically from a low of U.S. $7,000 per kilowatt to as high as U.S. $100,000 per kilowatt, is prohibitively high for terrestrial applications wherein they must compete against conventional generators. While much of this cost is due to the high quality control standards required for spacecraft components, a substantial portion is due to the high cost of preparing silicon crystals of the required purity and due to the inefficiencies of the batch processes by which such cells are fabricated.

While thin film photovoltaic cells possess many potential advantages over silicon cells in terrestrial applications, the fabrication and use of thin film cells has historically been plagued with problems of low yield, non-reproducibility and unreliability. Thin film photovoltaic cells employing thin films of polycrystalline material, such as cadmium sulfide or cadmium zinc sulfide and copper sulfide, offer substantial advantages for the development of continuous processing techniques, and they are flexible and light of weight. Consequently, they offer much promise as solar cells which can be easily fabricated, transported and deployed over large areas. Unfortunately, thin film cells of good efficiency have been difficult to reproduce consistently, and the operating lifetime of the cells produced has been uncertain.

Accordingly, there is a need for a method for making thin film photovoltaic cells with greater yield, reproducibility and reliability.

The present invention is based on the recognition that a primary source of failure in thin film photovoltaic cells, both in manufacturing and in field deployment, is caused by the undesirable short circuits or shunt diode formation between materials which are not intended to be in electrical contact with one another. Specifically, applicant has recognized that in front wall configuration photovoltaic cells, three major failure mechanisms are unwanted short circuits (1) between the transparent and opaque contacts, (2) between the transparent contact and the collector-converter and (3) between the absorber-generator and the opaque contact. In back wall configuration cells, unwanted short circuits develop (1) between the contacts, (2) between the transparent contact and the absorber-generator and (3) between the collector-converter and the opaque contact.

According to a first aspect to the present invention, there is provided a method of

**0010359**

fabricating a thin film photovoltaic device having as its components a transparent electrical contact and an opaque electrical contact with an intermediate pair of mutually overlapping semiconductor layers being located between said electrical contacts, said intermediate pair of semiconductor layers forming a photovotaic junction therebetween and functioning as a collector-converter and as an absorber-generator, respectively, wherein an electrical blocking layer adjoining one of the electrical contacts is formed in the electrical path between said transparent and said opaque electrical contacts to present undesired electrical contact between the electrical contact adjoining the blocking layer and the other components of the device not adjoining the blocking layer, characterised by the fact that said blocking layer (16 or 36) is formed with discontinuities therein to provide electrical contact between the components adjoining the blocking layer through the discontinuities.

According to a second aspect of the present invention, there is provided a thin film photovoltaic device having as the components a transparent electrical contact and an opaque electrical contact with an intermediate overlapping pair of semiconductor layers being located between said electrical contacts, said intermediate pair of semiconductor layers forming a photovoltaic junction therebetween and functioning as a collector-converter and as an absorber-generator, respectively, wherein a blocking layer adjoining one of the electrical contacts is disposed in the electrical path between said transparent and said opaque electrical contacts to prevent undesired electrical contact between the electrical contact adjoining the blocking layer and the other components of the device not adjoining the blocking layer, characterised by the fact that said blocking layer has discontinuities therein to provide electrical connection between the components adjoining the blocking layer through the discontinuities.

In order that the invention may be fully understood, it will now be described with reference to the accompanying drawings, in which:

Figure 1 is a schematic cross-sectional view of a front wall thin film photovoltaic cell wherein blocking layers are located on portions of the collector that are not covered by the absorber and between the collector and opaque electrical contact;

Figure 2 is a cross-sectional view taken through Figure 1 along the line 2—2;

Figure 3 is a view similar to Figure 1 of a further embodiment showing different locations for the blocking layers;

Figure 4 is a cross-sectional view similar to Figure 3 but showing the junction between the absorber and collector as of a hill and valley type construction;

Figure 5 is a view similar to Figure 3 but exemplifies one form of back wall cell; and

Figure 6 is a flow diagram indicating the steps for forming the cell of Figure 1.

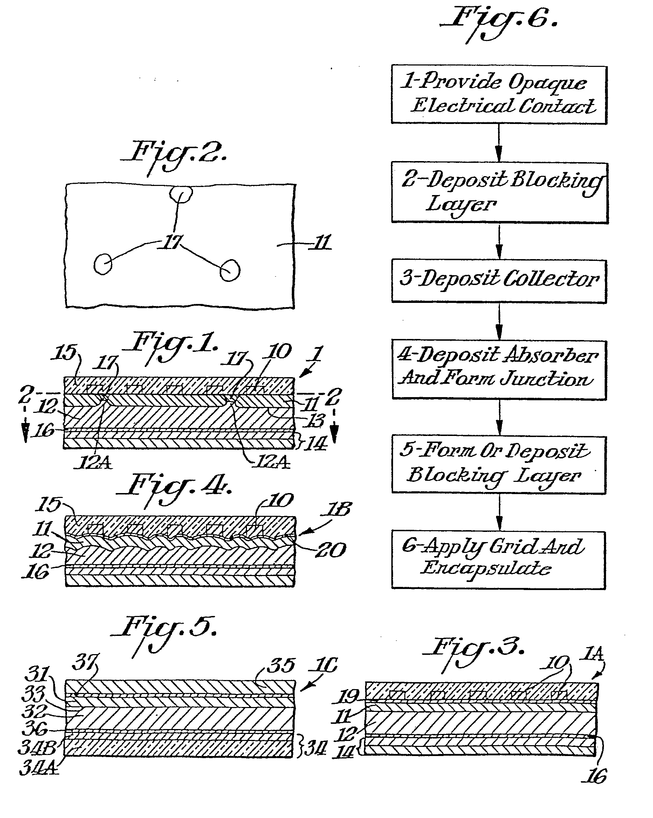

Fig. 1 illustrates a typical front wall thin film photovoltaic solar cell 1. In general, solar cell 1 comprises as successive components in the electrical path, a transparent electrical contact means 10 such as a gold, silver, nickel, copper or metal alloy grid electrode or conductive glass; an absorber-generator 11, such as a thin film of copper sulfide, disposed in electrical contact with grid electrical contact 10; a collector-converter 12, such as a film of cadmium sulfide or cadmium zinc sulfide, disposed in contact with the absorber and forming an electrical junction 13, therewith; and an opaque electrical contact 14, such as a layer of zinc plated copper foil or brass making electrical contact with the collector 12. In a typical thin film photovoltaic device, the copper sulfide absorber will have a thickness on the order of 1000 to 5000 angstroms; the cadmium sulfide or cadmium zinc sulfide collector will have a thickness of approximately 2 to 40 microns; and the zinc-plated copper foil contact will have a copper foil thickness of 15 to 30 microns and the zinc plate thickness of about 0.1 to 1 micron. In addition, the grid-covered absorber surface of the device is conveniently encapsulated in transparent glass 15 to protect the exposed surface from oxidation, contaminants and physical damage. Since opaque contact 14 comprises a substrate for the remaining components, it is referred to as a first electrical contact and electrical contact 10 is referred to as a second electrical contact. Similarly, for the sake of simplicity, the absorber and collector may also be referred to simply as "semiconductors".

Applicant has recognized that in such thin film cells flaws occur such as physical, metallurgical and electrical inhomogeneities. These flaws may be, for example, voids, discontinuities or such inhomogeneities as changes in the concentration of carriers, impurities, dopants, constituent elements and traps. Fig. 2, for example, indicates typical discontinuities which would result in the absorber layer whereby undesired electrical contact would otherwise result between the transparent contact 10 and the collector 12 but which is avoided by the present invention. It is to be understood that the present invention is concerned with such electrical path failures, as opposed to optical path failures, which may be opens, shorts, shunts or series resistances. In general, the invention comprises avoiding such undesired electrical contacts by locating a blocking layer between the components which should not electrically contact each other.

The blocking layers may take various forms. For example, a semiconductor material such as zinc sulfide may be deposited in the electrical path. It if also possible in the practice of the invention to utilize an insulating layer which includes materials having resistivity in the insulative range. Since the insulating layer would likewise be extremely thin, discontinuities would also result in the layer so that there is proper electrical contact between adjacent components of the cell in the areas of blocking layer discontinuities. These discontinuities in the insulative blocking area may also be deliberately introduced by varying the means of application. The likelihood of a blocking layer discontinuity overlapping or being aligned with a semiconductor (i.e. collector or absorber) discontinuity is so highly improbable that it should, for all intents and purposes, be discounted. Thus, the application of the blocking layer, even with its own discontinuities, will effectively function to carry out the objectives of this invention.

The invention may further be practiced by having the blocking layer result from the reaction of the exposed areas of the semiconductor, i.e. where one semiconductor is exposed through the discontinuities of the other semiconductor. In this respect, for example, the exposed portions of the semiconductor may be reacted with a specific ambient such by heating in air to result in the formation of the blocking layer only in those areas of discontinuity.

The type of a specific blocking layer material can accordingly widely vary. Thus as indicated above, the blocking layer can comprise a thin layer or semiconductor material having an electron affinity which will lead to the formation of a heterojunction or Schottky barrier junction which will not pass significant quantities of current at the normal operating voltage of the solar cell but which will make an ohmic contact with the successive component. Such a layer prevents unwanted short circuits by parallel semiconductor junction tailoring. Alternatively, the blocking layer can be a material which forms a rectifying contact with the non-successive layer. Further, the blocking layer can be a layer of insulating material selectively formed to insulate in regions of probable shorting.

In the specific embodiment of Figs. 1—2, blocking layer 16 is formed to prevent undesired electrical contact between transparent contact 10 and opaque contact 14 and between absorber 11 and opaque contact 14, while blocking layer 17 is formed to prevent undesired electrical contact between the transparent contact 10 and collector 12. Specifically, by locating blocking layer 16 in the electrical path between collector 12 and opaque contact 14, shorts are prevented between the two electrical contacts 10, 14 and between absorber 11 and opaque contact 14. Additionally, by locating blocking layer 17 in the areas of discontinuity of absorber 11, shorts are prevented between transparent contact 10 and collector 12.

Fig. 3 illustrates an alternative arrangement for the location of the blocking layers wherein layer 19 is located above absorber 11 and below transparent contact 10 in the cell 1A.

The front wall cells illustrated in Figs. 1 and 3 schematically show the various layers to be planar. This planar structure may be achieved through the natural deposition process or by chemically polishing the components. It is possible, however, to form the junction non-planar or irregular between the collector and absorber with hills and valleys whereby instead of chemically polishing, a conventional pre-etching technique is used to result in a texturing effect such as illustrated in Fig. 4. It is noted that, for the sake of simplicity, Fig. 4 shows the irregularities in exaggerated geometrically smooth hills and valleys. It is to be understood that the concepts of this invention may be practiced with both planar and textured structures. Thus, for example, Fig. 4 illustrates blocking layer 20 to be located at the junction between absorber 11 and transparent contact 10 in the cell 1B.

Fig. 5 also illustrates the application of the invention to back wall cells. In this respect, back wall cell 1C includes, for example, a glass substrate 34A having a conductive layer 34B such as tin oxide thereon to comprise transparent contact 34. The back wall cell 1C also includes collector 32 which may be, for example, cadmium sulfide or cadmium zinc sulfide forming a junction 33 with absorber 31 which may be copper sulfide and finally opaque contact 35 which may be copper. Blocking layers 36 and 37 are provided in the same manner as with the front wall cells.

Fig. 6 illustrates a flow diagram for forming a cell 1 of Figs. 1—2. In essence, the method of fabricating photovoltaic cell 1 involves the steps of providing a first electrical contact 14, depositing a collector-converter 12 on the first contact, depositing an absorber-generator 11 on the collector-converter 12 to form junction 13 therebetween, and applying a second electrical contact 10 and encapsulation means 15 to the absorber-generator. In accordance with the invention, this method further comprises the steps of providing between the electrical contacts blocking layers 16 and 17 of material for preventing undesired short circuits between non-successive layers without substantially interfering with the electrical flow between successive layers.

As illustrated in Fig. 6, the first step involves providing an opaque electrical contact 14 which is conveniently used as a substrate during the remainder of the process. In the fabrication of the device of Fig. 1, this step is preferably effectuated by (a) providing copper foil, (b) cleaning the foil surfaces electrolytically and by immersion in sulphuric acid, and (c) depositing a thin layer of zinc on the cleaned surface by electroplating.

The next step involves forming blocking layer 16 which is preferably a layer of zinc sulfide. Such a layer is formed by depositing a 0.1 to 2 micron average thickness layer of zinc sulfide by vacuum evaporation, sputtering or by chemical deposition.

Blocking layer 16 may alternatively be oxides or nitrides. As previously indicated, where an insulating blocking layer material is used because the layer is so thin, discontinuities would form or would be deliberately formed in the blocking layer itself so as to permit the desired electrical contact between opaque contact 14 and collector 12.

The next step involves depositing a collector-converter. In fabricating the device of Fig. 1, this step is preferably effected by evaporation, sputtering or chemical deposition of a cadmium sulfide or cadmium zinc sulfide collector. The collector surface can also be textured as by etching in hydrochloric acid, to promote efficient light collection. A four second dip in 55% v/v concentration HCl at 60°C, has been found satisfactory.

The next step involves depositing an absorber-generator on the collector and forming a junction 13 between the absorber and the collector. In the fabrication of the Fig. 1 device, this step is preferably effectuated by growing $Cu_2S$ on the CdS by an ion exchange process using an aqueous solution of cuprous chloride. A ten second dip has been found satisfactory in the following bath composition from which oxygen has been excluded:

| Component | Quantity |
|---|---|
| Deionized water | 4 liters |
| CuCl | 24 grams |
| NaCl | 8 grams |
| HCl | Sufficient to produce pH of 2—3 |
| Temperature | 98—100°C. |

Alternately, the cuprous chloride can be vapor deposited.

The resulting structure is then heat treated in a reducing atmosphere to form an acceptable junction 13 between the cadmium sulfide and the copper sulfide. During the heat treatment, copper sulfide diffuses into the cadmium sulfide and "dopes" it in the interfacial region. In addition, the reducing atmosphere chemically reduces oxides, such as $Cu_2O$, that form on the free surface of the $Cu_2S$. A fifteen-hour heat treatment in a 90% argon—10% hydrogen atmosphere at 170°C. has been found satisfactory. Alternatively, heat treatment at higher temperatures and shorter times is also satisfactory.

As illustrated in Figs. 1—2, applicant has recognized that discontinuities occur in absorber 11. Such discontinuities may be considered as holes or open spaces in the copper sulfide or other absorber material whereby in these open spaces the cadmium sulfide collector is exposed. Such discontinuities might also extend through the collector whereby, for example, portions of the zinc sulfide blocking layer could be exposed. Fig. 1 shows the discontinuities in absorber 11 in exaggerated form to facilitate a better understanding of the invention. In the embodiment of Fig. 1, the device is heated in the presence of a specific liquid or gaseous (such as air) ambient so that a reaction occurs at the exposed portions 12A of collection 12 to result in blocking layer 17 being formed at the spaced areas in which discontinuities of absorber 11 occur. In the embodiment illustrated in Figs. 1—2, blocking layer 17 is formed of cadmium sulfate on the exposed portions of cadmium sulfide by heating the structure in an oxygen containing atmosphere such as air as the ambient at a temperature of 200°C. For two minutes. Alternatively, a blocking layer could be applied over the whole absorber surface including the areas of discontinuity. One example of this alternative would be the deposition of copper oxide by evaporation or sputtering deposition of copper and the formation of copper oxide by oxidation.

The transparent contact 10 is then formed and is preferably a conductive glass or a grid applied by printing or vacuum evaporation through a suitable mask (or a conductive glass) and glass may be used as encapsulant 15.

The cells illustrated in Figs. 3—5 include blocking layers formed by depositing the desired material at the locations indicated therein in a manner similar to the formation of blocking layer 16 of Fig. 1. In this respect, blocking layers 19 (Fig. 3), 20 (Fig. 4) and 36 and 37 (Fig. 5) would comprise an entire layer except for the discontinuities that would result from this application similar to layer 16 in contrast to simply forming a layer at isolated locations such as layer 17. The upper blocking layer may be an oxide, a sulfate or other insulating material and thus is not necessarily limited to cadmium sulfate.

As emphasized above, the blocking layer may be selected from a wide range of materials. It is preferred that the specific material, however, be "chemically compatible" with at least one of the semiconductors (absorber and collector). The term "chemically compatible" is used in this application to mean a material which results from the reaction of a specific ambient with exposed portions of the otherwise remote semiconductor and is also used to mean a blocking layer material (such as zinc sulfide) having a chemical component in common with at least one semiconductor (such as cadmium sulfide collector 12).

It is to be understood that throughout this specification a layer comprising cadmium sulfide is intended to mean not only a layer of pure cadmium sulfide but also of related materials containing cadmium sulfide wherein the characteristics of the cadmium sulfide predominate, such as a layer of cadmium sulfide including a minor proportion of another metal, such as zinc, in an alloy such as cadmium zinc sulfide including 10 to 30 per cent of zinc in place of cadmium. Similarly, reference to layers comprising zinc sulfide is intended to include zinc cadmium sulfide with a minor proportion of cadmium. In addition, it should be noted that, in the context of this specification, materials which are technically classifiable as semiconductors, may nonetheless be sufficiently restrictive of current that they can, and do, effectively operate as insulators. In addition, the term "layer" as used herein encompasses not only a continuous layer, but, in addition, a discontinuous layer selectively formed where needed at a plurality of spots.

While the invention has been described in connection with but a small number of specific embodiments, it is to be understood that these are merely illustrative of many other specific embodiments which can also utilize the principles of the invention.

**Claims**

1. A method of fabricating a thin film photovoltaic device having as its components a transparent electrical contact and an opaque electrical contact with an intermediate pair of mutually overlapping semiconductor layers being located between said electrical contacts, said intermediate pair of semiconductor layers forming a photovoltaic junction therebetween and functioning as a collector-converter and as an absorber-generator, respectively, wherein an electrical blocking layer adjoining one of the electrical contacts is formed in the electrical path between said transparent and said opaque electrical contacts to prevent undesired electrical contact between the electrical contact adjoining the blocking layer and the other components of the device not adjoining the blocking layer, characterised by the fact that said blocking layer (16 or 36) is formed with discontinuities therein to provide electrical contact between the components adjoining the blocking layer through the discontinuities.

2. A method according to claim 1, characterised by the fact that said blocking layer (16 or 36) is disposed adjacent said collector-converter (12) and remote from said absorber generator (11).

3. A method according to claim 2, characterised by the fact that said blocking layer (16 or 36) is formed of a layer of zinc sulfide.

4. A method according to claim 2, characterised by the fact that said blocking layer (16 or 36) is formed of a semiconductor material.

5. A method according to claim 2, characterised by the fact that said blocking layer (16) is located adjacent to said opaque electrical contact (14).

6. A method according to claim 5, wherein said device is a front wall cell, characterised by the fact that said transparent electrical contact (10) is formed of a conductive glass having a transparent encapsulant layer (15) thereover.

7. A method according to claim 5, wherein said device is a front wall cell, characterized by the fact that said transparent electrical contact (10) is formed of a metallic grid having a transparent encapsulation layer (15) thereover.

8. A method according to claim 2, characterized by the fact that said blocking layer is located adjacent to said transparent electrical contact (10).

9. A method according to claim 8, wherein said device is a back wall cell, characterized by the fact that said transparent electrical contact (10) is formed of a glass substrate (34A) having a transparent conductive layer (34B) thereon.

10. A method according to claim 2, characterized by the fact that said junction between said mutually overlapping semiconductor layers is formed non-planarly as hills and valleys.

11. A method according to claim 2, characterized by the fact that said blocking layer (16 or 36) is formed of a material which is chemically compatible with at least one of said semiconductor layers.

12. A method according to claim 11, characterized by the fact that said blocking layer is rendered chemically compatible by being formed of a material having a chemical component in common with at least one of said semiconductor layers.

13. A method according to claim 12, characterized by the fact that said absorber-generator (11) is made from copper sulfide, said collector-converter (12) being made from cadmium sulfide, and said blocking layer (16) being made from zinc sulfide.

14. A method according to claim 1, characterized by the fact that one (11) of said semiconductor layers is formed with discontinuities through which the other (12) of said semiconductor layers is exposed, and that a further blocking layer (17) without discontinuities is formed only in the exposed areas of said other semiconductor layer.

15. A method according to claim 14, characterized by the fact that said blocking layer (17) without discontinuities is formed by reacting said exposed areas of said other semiconductor layer (12) with a liquid or gas ambient.

16. A method according to claim 15, characterized by the fact that said other semiconductor layer (12) is made of cadmium sulfide and said blocking layer (17) without discontinuities is made of cadmium sulfate.

17. A method according to claim 1, characterized by the fact that said blocking layer (16 or 36) with discontinuities is made from an insulating material.

18. A method according to claim 15, characterized by the fact that the blocking layer (16) having discontinuities is located adjacent to said opaque electrical contact (14).

19. A method according to claim 18, characterized by the fact that a further blocking layer (17) without discontinuities is located adjacent to said transparent electrical contact (10).

20. A method according to claim 14, characterized by the fact that the absorber-generator (11) is made from copper sulfide, the collector-converter (12) being made from cadmium sulfide, said blocking layer (16) having discontinuities being made from zinc sulfide, and said further blocking layer (17) without discontinuities being made from cadmium sulfate.

21. A thin film photovoltaic device having as its components a transparent electrical contact and an opaque electrical contact with an intermediate overlapping pair of semiconductor layers being located between said electrical contacts, said intermediate pair of semiconductor layers forming a photovoltaic junction therebetween and functioning as a collector-converter and as an absorber-generator, respectively, wherein a blocking layer adjoining one of the electrical contacts is disposed in the electrical path between said transparent and said opaque electrical contacts to prevent undesired electrical contact between the electrical contact adjoining the blocking layer and the other components of the device not adjoining the blocking layer, characterised by the fact that said blocking layer (16 or 36) has discontinuities therein to provide electrical connection between the components adjoining the blocking layer through the discontinuities.

22. A device according to claim 21, characterised by the fact that said blocking layer (16 or 36) is disposed adjacent said collector-converter (12 or 32) and remote from said absorber generator (11 or 31).

23. A device according to claim 22, characterised by the fact that said blocking layer (16 or 36) is a layer of zinc sulfide.

24. A device according to claim 22, characterised by the fact that said blocking layer (16 or 36) is a semiconductor material.

25. A device according to claim 22, characterised by the fact that said blocking layer (16) is located adjacent to said opaque electrical contact (14).

26. A device according to claim 25, characterised by the fact that said transparent electrical contact (10) is in the form of a conductive glass having a transparent encapsulation layer (15) thereover.

27. A device according to claim 25, characterized by the fact that said transparent electrical contact (10) is in the form of a metallic grid having a transparent encapsulation layer (15) thereover.

28. A device according to claim 22, characterized by the fact that said blocking layer (36) is located adjacent to said transparent electrical contact (34).

29. A device according to claim 22, characterized by the fact that said junction (13) between said semiconductor layers (11, 12) is non-planar in the form of hills and valleys.

30. A device according to claim 21, characterized by the fact that said blocking layer (16 or 36) is a material which is chemically compatible with at least one of said semiconductor layers (11, 12; 31, 32), said material having a chemical component in common with said at least one of said semiconductors.

31. A device according to claim 30, characterized by the fact that said absorber-generator (11 or 31) is made from copper sulfide, said collector-converter (12 or 32) being made from cadmium sulfide or cadmium zinc sulfide, and said blocking layer (16 or 36) being made from zinc sulfide.

32. A device according to claim 21, characterized by the fact that one (11) of said semiconductor layers (11, 12) has discontinuities through which the other (12) of said semiconductor layers is exposed, and that a further blocking layer (17) without discontinuities is disposed only in the exposed areas of said other semiconductor (12).

33. A device according to claim 32, characterized by the fact that said other semiconductor layer (12) is made of cadmium sulfide or cadmium zinc sulfide and said blocking layer (17) without discontinuities is cadmium sulfate.

34. A device according to claim 21, characterized by the fact that said blocking layer (16 or 36) is made from an insulating material.

35. A device according to claim 32, characterized by the fact that the absorber-generator (11) is made from copper sulfide, the collector-converter (12) is made from cadmium sulfide, the blocking layer (17) without discontinuities is made from cadmium sulfate, and the blocking layer (16) with discontinuities is made from zinc sulfide.

36. A device according to claim 35, characterized by the fact that the copper sulfide absorber-generator (11) has discontinuities therein which cause portions of the cadmium sulfide collector-converter (12) to be exposed, and that the cadmium sulfate blocking layer (16) is disposed only at said exposed portions of said cadmium sulfide collector-converter.

37. A device according to claim 21, characterized by the fact that the blocking layer (19, 20 or 36) is formed from copper oxide and is located between said absorber-generator (11 or 31) and said transparent electrical contact (10 or 34).

**Patentansprüche**

1. Verfahren zur Herstellung eines Dünnschicht-Photoelements mit einem lichtdurchlässigen elektrischen Kontakt, einem lichtundurchlässigen elektrischen Kontakt und zwei zwischen diesen elektrischen Kontakten angeordneten, einander überlappenden Halbleiterschichten, zwischen denen ein photovoltaischer Übergang vorhanden ist und die als Kollektor und Wandler bzw. als Absorber und Generator wirksam sind, wobei in dem Stromweg zwischen dem lichtdurchlässigen und dem lichtundurchlässigen elektrischen Kontakt eine an einen dieser Kontakte angrenzende elektrische Sperrschicht ausgebildet wird, die eine unerwünschte elektrisch leitende Berührung zwischen dem an die Sperrschicht angrenzenden elektrischen Kontakt und anderen, nicht an die Sperrschicht angrenzenden Teilen des Photoelements verhindert, dadurch gekennzeichnet, daß in der genannten Sperrschicht (16 oder 36) Unstetigkeitsstellen ausgebildet werden, durch die hindurch eine elektrisch leitende Berührung zwischen den an die Sperrschicht angrenzenden Teilen stattfindet.

2. Verfahren nach Anspruch 1, dadurch gekennzeichnet, daß die Sperrschicht (16 oder 36) im Bereich des Kollektors und Wandlers (12) und entfernt von dem Absorber und Generator (11) angeordnet ist.

3. Verfahren nach Anspruch 2, dadurch gekennzeichnet, daß die Sperrschicht (16 oder 36) aus einer Schicht aus Zinksulfid hergestellt wird.

4. Verfahren nach Anspruch 2, dadurch gekennzeichnet, daß die Sperrschicht (16 oder 36) aus Halbleitermaterial hergestellt wird.

5. Verfahren nach Anspruch 2, dadurch gekennzeichnet, daß die Sperrschicht (16) im Bereich des lichtundurchlässigen elektrischen Kontakts (14) angeordnet wird.

6. Verfahren nach Anspruch 5, in dem das Photoelement eine Vorderwandzelle ist, dadurch gekennzeichnet, daß der lichtdurchlässige elektrische Kontakt (10) aus einem leitenden Glas hergestellt wird, über dem eine lichtdurchlässige Einkapselungsschicht (15) angeordnet ist.

7. Verfahren nach Anspruch 5, in dem das Photoelement eine Vorderwandzelle ist, dadurch gekennzeichnet, daß der lichtdurchlässige elektrische Kontakt (10) in Form eines Metallgitters hergestellt wird, über dem eine lichtdurchlässige Einkapselungsschicht (15) angeordnet wird.

8. Verfahren nach Anspruch 2, dadurch gekennzeichnet, daß die Sperrschicht im Bereich des lichtdurchlässigen elektrischen Kontakts (10) angeordnet wird.

9. Verfahren nach Anspruch 8, in dem das Photoelement eine Rückwandzelle ist, dadurch gekennzeichnet, daß der lichtdurchlässige elektrische Kontakt (10) in Form eines Glassubstrats (34A) hergestellt wird, über dem eine lichtdurchlässige leitende Schicht (34B) angeordnet wird.

10. Verfahren nach Anspruch 2, dadurch gekennzeichnet, daß der Übergang zwischen den einander überlappenden Halbleiterschichten nichtebenflächig und mit Bergen und Tälern ausgebildet wird.

11. Verfahren nach Anspruch 2, dadurch gekennzeichnet, daß die Sperrschicht (16 oder 36) aus einem Material hergestellt wird, das mit mindestens einer der Halbleiterschichten chemisch verträglich ist.

12. Verfahren nach Anspruch 11, dadurch gekennzeichnet, daß die Sperrschicht dadurch chemisch verträglich gemacht wird, daß sie aus einem Material hergestellt wird, das einen chemischen Bestandteil enthält, der auch in mindestens einer der Halbleiterschichten vorkommt.

13. Verfahren nach Anspruch 12, dadurch gekennzeichnet, daß der Absorber und Generator (11) aus Kupfersulfid, der Kollektor und Wandler (12) aus Cadmiumsulfid und die Sperrschicht (16) aus Zinksulfid hergestellt wird.

14. Verfahren nach Anspruch 1, dadurch gekennzeichnet, daß eine (11) der Halbleiterschichten mit Unstetigkeitsstellen ausgebildet wird, durch die hindurch die andere (12) Halbleiterschicht freiliegt, und daß nur in den freiliegenden Bereichen dieser anderen Halbleiterschicht eine von Unstetigkeitsstellen freie Sperrschicht (17) ausgebildet wird.

15. Verfahren nach Anspruch 14, dadurch gekennzeichnet, daß die von Unstetigkeitsstellen freie Sperrschicht (17) dadurch gebildet wird, daß die genannten freiliegenden Bereiche der genannten anderen Halbleiterschicht (12) mit einer in der Umgebung vorhandenen, flüssigen oder gasförmigen Substanz umgesetzt werden.

16. Verfahren nach Anspruch 15, dadurch gekennzeichnet, daß die genannte andere Halbleiterschicht (12) aus Cadmiumsulfid und die von Unstetigkeitsstellen freie Sperrschicht (17) aus Cadmiumsulfat hergestellt wird.

17. Verfahren nach Anspruch 1, dadurch gekennzeichnet, daß die Unstetigkeitsstellen enthaltende Sperrschicht (16 oder 36) aus Isoliermaterial hergestellt wird.

18. Verfahren nach Anspruch 15, dadurch gekennzeichnet, daß die Unstetigkeitsstellen enthaltende Sperrschicht (16) im Bereich des lichtundurchlässigen elektrischen Kontakts (14) angeordnet wird.

19. Verfahren nach Anspruch 18, dadurch gekennzeichnet, daß die von Unstetigkeitsstellen freie Sperrschicht (17) im Bereich des lichtdurchlässigen elektrischen Kontakts (10) angeordnet wird.

20. Verfahren nach Anspruch 14, dadurch gekennzeichnet, daß der Absorber und Generator (11) aus Kupfersulfid, der Kollektor und Wandler (12) aus Cadmiumsulfid, die Unstetigkeitsstellen enthaltende Sperrschicht (16) aus Zinksulfid und die andere, von Unstetigkeitsstellen freie Sperrschicht (17) aus Cadmiumsulfat hergestellt wird.

21. Dünnschicht-Photoelement mit einem lichtdurchlässigen elektrischen Kontakt, einem lichtundurchlässigen elektrischen Kontakt und zwei zwischen diesen elektrischen Kontakten angeordneten, einander überlappenden Halbleiterschichten, zwischen denen ein photovoltaischer Übergang vorhanden ist und die als Kollektor und Wandler bzw. als Absorber und Generator wirksam sind, wobei in dem Stromweg zwischen dem lightdurchlässigen und dem lichtundurchlässigen elektrischen Kontakt eine an einen dieser Kontakte angrenzende elektrische Sperrschicht ausgebildet wird, die eine unerwünschte elektrisch leitende Berührung zwischen dem an die Sperrschicht angrenzenden elektrischen Kontakt und anderen, nicht an die Sperrschicht angrenzenden Teilen des Photoelements verhindert, dadurch gekennzeichnet, daß die genannte Sperrschicht (16 oder 36) Unstetigkeitsstellen enthält, durch die hindurch die an die Sperrschicht angrenzenden Teile elektrisch miteinander verbunden sind.

22. Photoelement nach Anspruch 21, dadurch gekennzeichnet, daß die Sperrschicht (16 oder 36) im Bereich des Kollektors und Wandlers (12 oder 32) und entfernt von dem Absorber und Generator (11 oder 31) angeordnet ist.

23. Photoelement nach Anspruch 22, dadurch gekennzeichnet, daß die Sperrschicht (16 oder 36) eine Zinksulfidschicht ist.

24. Photoelement nach Anspruch 22, dadurch gekennzeichnet, daß die Sperrschicht (16 oder 36) aus Halbleitermaterial besteht.

25. Photoelement nach Anspruch 22, dadurch gekennzeichnet, daß die Sperrschicht (16) im Bereich des lichtundurchlässigen elektrischen Kontakts (14) angeordnet ist.

26. Photoelement nach Anspruch 25, dadurch gekennzeichnet, daß der lichtdurchlässige elektrische Kontakt (10) aus einem leitenden Glas besteht, über dem eine lichtdurchlässige Einkapselungsschicht (15) angeordnet ist.

27. Photoelement nach Anspruch 25, dadurch gekennzeichnet, daß der lichtdurchlässige elektrische Kontakt (10) aus einem Metallgitter besteht, über dem eine lichtdurchlässige Einkapselungsschicht (15) angeordnet ist.

28. Photoelement nach Anspruch 22, dadurch gekennzeichnet, daß die Sperrschicht (36) im Bereich des lichtdurchlüssigen elektrischen Kontakts (34) angeordnet ist.

29. Photoelement nach Anspruch 22, dadurch gekennzeichnet, daß der genannte Übergang (13) zwischen den Halbleiterschichten (11, 12) nichtebenflächig und mit Bergen und Tälern ausgebildet ist.

30. Photoelement nach Anspruch 21, dadurch gekennzeichnet, daß die Sperrschicht (16 oder 36) aus einem Material besteht, das mit mindestens einer der Halbleiterschichten (11, 12; 31, 32) chemisch verträglich ist und einen chemischen Bestandteil enthält, der auch in der genannten mindestens einen Halbleiterschicht vorhanden ist.

31. Photoelement nach Anspruch 30, dadurch gekennzeichnet, daß der Absorber und Generator (11 oder 31) aus Kupfersulfid, der Kollektor und Wandler (12 oder 32) aus Cadmiumsulfid und die Sperrschicht (16 oder 36) aus Zinksulfid besteht.

32. Photoelement nach Anspruch 21, dadurch gekennzeichnet, daß eine (11) der Halbleiterschichten (11, 12) Unstetigkeitsstellen enthält, durch die hindurch die andere (12) Halbleiterschicht freiliegt, und daß nur in den freiliegenden Bereichen dieser anderen Halbleiterschicht (12) eine von Unstetigkeitsstellen freie Sperrschicht (17) verhanden ist.

33. Photoelement nach Anspruch 32, dadurch gekennzeichnet, daß genannte andere Halbleiterschicht (12) aus Cadmiumsulfid und die von Unstetigkeitsstellen freie Sperrschicht (17) aus Cadmiumsulfat besteht.

34. Photoelement nach Anspruch 21, dadurch gekennzeichnet, daß die Sperrschicht (16 oder 36) aus Isoliermaterial besteht.

35. Photoelement nach Anspruch 32, dadurch gekennzeichnet, daß der Absorber und Generator (11) aus Kupfersulfid, der Kollektor und Wandler (12) aus Cadmiumsulfid, die von Unstetigkeitsstellen freie Sperrschicht (17) aus Cadmiumsulfat und die Unstetigkeitsstellen enthaltende Sperrschicht (16) aus Zinksulfid besteht.

36. Photoelement nach Anspruch 35, dadurch gekennzeichnet, daß der Absorber und Generator (11) aus Kupfersulfid Unstetigkeitsstellen enthält, durch die hindurch Teile des Kollektors und Wandlers (12) aus Cadmiumsulfid freiliegen, und daß die Sperrschicht (16) aus Cadmiumsulfat nur an den freiliegenden Bereichen des Kollektors und Wandlers aus Cadmiumsulfid vorgesehen ist.

37. Photoelement nach Anspruch 21, dadurch gekennzeichnet, daß die Sperrschicht (19, 20 oder 36) aus Kupferoxid besteht und zwischen dem Absorber und Generator (11 oder 31) und dem lichtdurchlässigen elektrischen Kontakt (10 oder 34) angeordnet ist.

## Revendications

1. Procédé de fabrication d'un dispositif photovoltaïque à couche mince comportant comme composante un contact électrique transparent et un contact électrique opaque, une paire intermédiaire de couches semiconductrices se recouvrant mutuellement étant placée entre lesdits contacts électriques, ladite paire intermédiaire de couches semiconductrices formant une jonction voltaïque entre elles et fonctionnant respectivement comme un collecteur-convertisseur et comme un absorbeur-générateur, suivant lequel une couche de blocage électrique adjacente à un des contacts électriques est formée dans la voie électrique entre lesdits contacts électriques transparent et opaque pour empêcher un contact électrique indésirable entre le contact électrique adjacent à la couche de blocage et les autres composants du dispositif non adjacents à la couche de blocage, caractérisé par le fait que ladite couche de blocage (16 ou 36) est pourvue intérieurement de discontinuités pour établir un contact électrique entre les composants adjacents à la couche de blocage par l'intermédiaire des discontinuités.

2. Procédé selon la revendication 1, caractérisé par le fait que ladite couche de blocage (16 ou 36) est adjacente audit collecteur-convertisseur (12) éloignée dudit absorbeur-générateur (11).

3. Procédé selon la revendication 2, caractérisé par le fait que ladite couche de blocage (16 ou 36) est formée d'une couche de sulfure de zinc.

4. Procédé selon la revendication 2, caractérisé en ce que ladite couche de blocage (16 ou 36) est formée d'une matière semiconductrice.

5. Procédé selon la revendication 2, caractérisé par le fait que ladite couche de blocage est adjacente audit contact électrique opaque (14).

6. Procédé selon la revendication 5, où ledit dispositif est une cellule de paroi avant, caractérisé en ce que ledit contact électrique transparent (10) est formé d'un verre conducteur portant une couche transparente d'enrobage (15).

7. Procédé selon la revendication 5, où ledit dispositif est une cellule de paroi avant, caractérisé par le fait que ledit contact électrique transparent (10) est formé d'une grille métallique portant une couche transparente d'enrobage (15).

8. Procédé selon la revendication 2, caractérisé par le fait que ladite couche de blocage est adjacente audit contact électrique transparent (10).

9. Procédé selon la revendication 8, où ledit dispositif est une cellule de paroi arrière, caractérisé par le fait que ledit contact électrique transparent (10) est formé d'un substrat en verre (34A) sur lequel est placé une couche conductrice transparente (34B).

10. Procédé selon la revendication 2, caractérisé par le fait que ladite jonction entre lesdites couches semiconductrices as recouvrant mutuellement est pourvue d'un profil non planaire sous forme de bosses et de creux.

11. Procédé selon la revendication 2, caractérisé par le fait que ladite couche de blocage (16 ou 36) est formée d'une matière qui est chimiquement compatible avec au moins une desdites couches semiconductrices.

12. Procédé selon la revendication 11, caractérisé par le fait que ladite couche de blocage est rendue chimiquement compatible en étant formée d'une matière contenant un composant chimique en commun avec au moins une desdites couches semiconductrices.

13. Procédé selon la revendication 12, caractérisé par le fait que ledit absorbeur-générateur (11) est formé de sulfure de cuivre, ledit collecteur-convertisseur (12) étant formé de sulfure de cadmium et ladite couche de blocage (16) étant formée de sulfure de zinc.

14. Procédé selon la revendication 1, caractérisé par le fait qu'une (11) desdites couches semiconductrices est formée de discontinuités par l'intermédiaire desquelles l'autre (12) desdites couches semiconductrices est disposée, et en ce qu'une couche de blocage (17) sans discontinuité est formée seulement dans les zones exposées de ladite autre couche semiconductrice.

15. Procédé selon la revendication 14, caractérisé par le fait que ladite couche de blocage (17) sans discontinuité est formée en faisant réagir lesdites zones exposées de ladite autre couche semiconductrice (12) avec un liquide ou un gaz ambiant.

16. Procédé selon la revendication 15, caractérisé par le fait que ladite autre couche semiconductrice (12) est formée de sulfure de cadmium, et en ce que ladite couche de blocage (17) sans discontinuité est formée de sulfate de cadmium.

17. Procédé selon la revendication 1, caractérisé par le fait que ladite couche de blocage (16 ou 36) sans discontinuité est formée d'une matière isolante.

18. Procédé selon la revendication 15, caractérisé par le fait que la couche de blocage (16) comportant des discontinuités est adjacente audit contact électrique opaque (14).

19. Procédé selon la revendication 18, caractérisé par le fait que la couche de blocage (17) sans discontinuité est adjacente audit contact électrique transparent (10).

20. Procédé selon la revendication 18, caractérisé par le fait que l'absorbeur-générateur (11) est formé de sulfure de cuivre, le collecteur-convertisseur (12) étant formé de sulfure de cadmium, ladite couche de blocage (16) comportant des discontinuités étant formée de sulfure de zinc et ladite autre couche de blocage (17) sans discontinuité étant formée de sulfate de cadmium.

21. Dispositif photovoltaïque à couche mince comportant comme composants un contact électrique transparent et un contact électrique opaque, une paire intermédiaire de couches semiconductrices se recouvrant étant placée entre lesdits contacts électriques, ladite paire intermédiaire de couches semiconductrices formant une jonction voltaïque entre elles et fonctionnant respectivement comme un collecteur-convertisseur et comme un absorbeur-générateur, dans lequel une couche de blocage adjacente à un des contacts électriques est disposée dans la voie électrique entre lesdits contacts électriques transparent et opaque pour empêcher un contact électrique indésirable entre le contact électrique adjacent à la couche de blocage et les autres composants du dispositif non adjacents à la couche de blocage, caractérisé par le fait que ladite couche de blocage (16 ou 36) comporte des discontinuités pour établir une connexion électrique entre les composants adjacents à la couche de blocage par l'intermédiaire des discontinuités.

22. Dispositif selon la revendication 21, caractérisé par le fait que ladite couche de blocage (16 ou 36) est adjacente audit collecteur-convertisseur (12 ou 32) et éloignée dudit absorbeur-générateur (11 ou 31).

23. Dispositif selon la revendication 22, caractérisé par le fait que ladite couche de blocage (16 ou 36) est une couche de sulfure de zinc.

24. Dispositif selon la revendication 22, caractérisé par le fait que ladite couche de blocage (16 ou 36) est une matière semiconductrice.

25. Dispositif selon la revendication 22, caractérisé par le fait que ladite couche de blocage (16) est adjacente audit contact électrique opaque (14).

26. Dispositif selon la revendication 25, caractérisé par le fait que ledit contact électrique transparent (10) se présente sous la forme d'un verre conducteur portant une couche transparente d'enrobage (15).

27. Dispositif selon la revendication 25, caractérisé par le fait que ledit contact électrique transparent (10) se présente sous forme d'une grille métallique portant une couche transparente d'enrobage (15).

28. Dispositif selon la revendication 22, caractérisé par le fait que ladite couche de blocage (36) est adjacente audit contact électrique transparent (34).

29. Dispositif selon la revendication 22, caractérisé par le fait que ladite jonction (13) entre lesdites couches semiconductrices (11, 12) n'est pas plane en se présentant sous formé de bosses et de creux.

30. Dispositif selon la revendication 21, caractérisé par le fait que ladite couche de blocage (16 ou 36) est une matière chimiquement compatible avec au moins une desdites couches semiconductrices (11, 12; 31, 32), ladite matière comportant un composant chimique en commun avec au moins un desdits semiconducteurs.

31. Dispositif selon la revendication 30, caractérisé par le fait que ledit absorbeur-générateur (11 ou 31) est formé de sulfure de cuivre, ledit collecteur-convertisseur (12 ou 32) étant formé de sulfure de cadmium ou de sulfure de cadmium-zinc, et ladite couche de blocage (16 ou 36) étant formée de sulfure de zinc.

32. Dispositif selon la revendication 21, caractérisé par le fait qu'une (11) desdites couches semiconductrices (11, 12) comporte des discontinuités par l'intermédiaire desquelles l'autre (12) desdites couches semiconductrices est exposée, et en ce qu'une couche de blocage (17) sans discontinuité est disposée seulement dans les zones exposées de ladite autre couche semiconductrice (12).

32. Dispositif selon la revendication 32, caractérisé par le fait que ladite autre couche semiconductrice (12) est formée de sulfure de cadmium ou de sulfure de cadmium-zinc, et en ce que ladite couche de blocage (17) sans discontinuité est formée de sulfate de cadmium.

34. Dispositif selon la revendication 21, caractérisé par le fait que ladite couche de blocage (16 ou 36) est formée d'une matière isolante.

35. Dispositif selon la revendication 32, caractérisé par le fait que l'absorbeur-générateur (11) est formé de sulfure de zinc, le collecteur-convertisseur (12) est formé de sulfure de cadmium, la couche de blocage (17) sans discontinuité est formée de sulfate de cadmium, et la couche de blocage (16) avec discontinuités est formée de sulfure de zinc.

36. Dispositif selon la revendication 35, caractérisé par le fait que l'absorbeur-générateur (11) en sulfure de cuivre contient des discontinuités qui provoquent l'exposition de parties du collecteur-convertisseur (12) en sulfure de cadmium, et en ce que la couche de blocage en sulfate de cadmium (16) est disposée seulement sur lesdites parties exposées dudit collecteur-convertisseur en sulfure de cadmium.

37. Dispositif selon la revendication 21, caractérisé par le fait que la couche de blocage (19, 20 ou 36) est formée d'oxyde de cuivre et est placée entre ledit absorbeur-générateur (11 ou 31) et ledit contact électrique transparent (10 ou 34).

0 0 10 359

*Fig.6.*

*Fig.2.*

*Fig.1.*

*Fig.4.*

*Fig.5.*

*Fig.3.*

1-Provide Opaque
Electrical Contact

2-Deposit Blocking
Layer

3-Deposit Collector

4-Deposit Absorber
And Form Junction

5-Form Or Deposit
Blocking Layer

6-Apply Grid And
Encapsulate

1